# EUROPÄISCHE PATENTSCHRIFT

(11) **EP 2 875 363 B1**
(45) Veröffentlichungstag und Bekanntmachung des Hinweises auf die Patenterteilung: **27.02.2019**
(21) Anmeldenummer: 13739401.1
(22) Anmeldetag: 15.07.2013
(51) Int. Cl.: G01R 19/14, H02S 50/10

(54) **DC-VERPOLUNGSERKENNUNG**
DC POLARITY REVERSAL DETECTOR
DÉTECTEUR D'INVERSION DE POLARITÉ C.C.

(30) Priorität: 20.07.2012 DE 102012106612
(43) Veröffentlichungstag der Anmeldung: 27.05.2015
(73) Patentinhaber: SMA Solar Technology AG, 34266 Niestetal (DE)
(72) Erfinder: SCHIELEIT, André, 34128 Kassel (DE)
(74) Vertreter: Lahnor, Peter
(86) Internationale Anmeldenummer: PCT/EP2013/064937
(87) Internationale Veröffentlichungsnummer: WO 2014/012900

(56) Entgegenhaltungen:
- EP-A1- 2 463 914
- CN-A- 102 193 049
- CN-U- 201 918 729
- DE-U1-202013 100 704
- FI-U1- 20120 004 097
- US-A1- 2008 074 097

## Beschreibung

### TECHNISCHES GEBIET DER ERFINDUNG

Die Erfindung betrifft eine Prüfvorrichtung zum Überprüfen von Polaritäten von einzeln an nicht miteinander verbundene Eingänge einer Kombinationsschaltung angeschlossenen Polen von Gleichspannungsquellen mit den Merkmalen des Oberbegriffs des Patentanspruchs 1.

Wenn mehrere Gleichspannungsquellen über eine Kombinationsschaltung zusammengefasst werden, ist an der Kombinationsschaltung für jeden Pol jeder Gleichspannungsquelle ein Eingang vorgesehen, wobei für jeden Eingang vorgegeben ist, welche Polarität der angeschlossene Pol aufweisen muss. Insbesondere können diese Polaritäten dadurch vorgegeben sein, dass die Kombinationsschaltung - oder eine daran angeschlossene weitere Schaltung - dazu vorgesehen ist, die Eingänge für Pole gleicher Polarität aller Gleichspannungsquellen miteinander zu verbinden. Um sicherzustellen, dass die Pole der Gleichspannungsquellen dafür an die richtigen Eingänge angeschlossen sind, sind ihre Polaritäten vor dem Verbinden zu überprüfen.

So findet die Prüfvorrichtung beispielsweise Einsatz beim Überprüfen der Polaritäten von an die Eingänge eines Wechselrichters oder einer separaten Kombinationsschaltung angeschlossenen Polen mehrerer Strings einer Photovoltaikanlage, bevor diese Eingänge miteinander verbunden werden, um die Strings parallel zu schalten.

### STAND DER TECHNIK

Aus der US 5 270 638 A ist eine Prüfvorrichtung zum Überprüfen von Polaritäten von Polen einer Gleichspannungsquelle bekannt. Dazu weist die Prüfvorrichtung zwei elektrische Kontakte auf, die mit den Polen der Gleichspannungsquelle verbindbar sind. Die beiden elektrischen Kontakte sind über eine Zwei-Farben-LED miteinander verbunden, die ein von der Polarität der Pole und der daraus resultierenden Stromrichtung abhängiges Signal ausgibt. Beispielsweise leuchtet die LED rot, wenn die Polarität der Spannung, welche an dem einen elektrischen Kontakt anliegt, gegenüber dem an dem anderen elektrischen Kontakt anliegenden elektrischen Potential positiv ist, wohingegen die LED bei umgekehrter Polarität grün leuchtet. Die Prüfvorrichtung weist zusätzlich einen weiteren elektrischen Kontakt auf, der über eine weitere zwei Farben-LED mit einem zu den ersten beiden elektrischen Kontakten parallel geschalteten Spannungsteiler verbunden ist. Von dieser weiteren LED wird so die Polarität einer Spannung, welche an dem weiteren elektrischen Kontakt anliegt, in Bezug auf das mittlere elektrische Potential der ersten beiden elektrischen Kontakte angezeigt.
Aus der CA 2 636 675 A1 ist eine Prüfvorrichtung zum Überprüfen von Polaritäten für eine elektronische Schnittstelle bekannt. Die Prüfvorrichtung weist dabei eine Mehrzahl von elektronischen Kontakten auf, von denen einer mit einer Spannungsquelle und ein anderer mit einem Erdanschluss verbindbar ist. Diese beiden elektrischen Kontakte sind über ein Signalelement miteinander verbunden. Das Signalelement zeigt das Vorzeichen, d. h. die Polarität der Spannung des mit der Spannungsquelle verbundenen Kontakts an, indem es ein von der Stromrichtung abhängiges Signal ausgibt. Das Signalelement kann dazu beispielsweise zwei antiparallel geschaltete LEDs aufweisen.

Aus der US 4,025,850 A, der US 3,600,678 A, der FI20120004097U und der US 4,233,560 A sind jeweils Vorrichtungen mit einem Signalelement bekannt, das bei einer Übereinstimmung der Polarität einer angelegten Spannung mit einer vorgegebenen Polarität mit einem elektrischen Signal zur Ausgabe eines Übereinstimmungssignals beaufschlagt wird. Darüber hinaus weisen einige der Vorrichtungen jeweils ein Schaltelement auf, das bei fehlender Übereinstimmung der Polarität das Signal zu dem Signalelement blockiert.
Aus der CN 201918729 U ist eine Verpolungsschutzschaltung mit dem Merkmal des Oberbegriffs des unabhängigen Patentanspruchs 1 für eine Ladevorrichtung zum Laden einer Batterie mit einem Solargenerator bekannt. Die Verpolungsschutzschaltung überwacht sowohl die Polarität der an zwei Eingänge der Ladevorrichtung angeschlossenen Pole des Solargenerators als auch die Polarität der an zwei weitere Eingänge der Ladevorrichtung angeschlossenen Pole der Batterie. Dabei ist einer der Eingänge für den Solargenerator direkt mit einem der Eingänge für die Batterie verbunden, während zwischen dem anderen Eingang für den Solargenerator und dem anderen Eingang für die Batterie zwei unidirektional sperrende Halbleiterschaltelemente mit antiparallelen Dioden einander entgegengesetzten Durchlassrichtungen angeordnet sind. Die Verpolungsschutzschaltung lässt ein Ansteuern der beiden selbstsperrenden Halbleiterschalter nur dann zu, wenn der Solargenerator und die Batterie mit richtiger Polarität angeschlossen sind. Bei Verpolung des Solargenerators oder der Batterie fließt ein Strom zwischen den beiden Eingängen eines jeweiligen Optokopplers, in dessen Folge der jeweilige Optokoppler zwischen seinen beiden Ausgängen leitfähig wird und dadurch ein Signal gesetzt wird, das die jeweilige Verpolung anzeigt.

### AUFGABE DER ERFINDUNG

Der Erfindung liegt die Aufgabe zugrunde, eine Prüfvorrichtung aufzeigen, mit der Polaritäten von Polen einer Vielzahl von Gleichspannungsquellen einfach überprüfbar sind, wobei die Pole einzeln an noch nicht miteinander verbundene Eingänge einer Kombinationsschaltung angeschlossen sind.

### LÖSUNG

Die Aufgabe der Erfindung wird erfindungsgemäß durch eine Prüfvorrichtung mit den Merkmalen des unabhängigen Patentanspruchs 1 gelöst. Bevorzugte Ausgestaltungen der erfindungsgemäßen Prüfvorrichtung sind den abhängigen Patentansprüchen zu entnehmen.

### BESCHREIBUNG DER ERFINDUNG

Der Erfindung liegt die Erkenntnis zugrunde, dass bei Verwendung der aus dem Stand der Technik bekannten Prüfvorrichtungen ein Überprüfen von Polaritäten von einzeln an noch nicht miteinander verbundene Eingänge einer Kombinationsschaltung angeschlossenen Polen einer Mehrzahl von Gleichspannungsquellen durch eine sukzessive Überprüfung der Polaritäten der Pole jeweils einer Gleichspannungsquelle erfolgt, wodurch sich das Überprüfen zeitaufwändig gestaltet. Zusätzlich ist ein hohes Maß an Sorgfalt erforderlich, um ein Vertauschen oder Auslassen von Polen, beispielsweise durch Überspringen, ausschließen zu können. Indem die Pole der Gleichspannungsquellen mit einer erfindungsgemäßen Prüfvorrichtung nicht wie aus dem Stand der Technik bekannt sukzessive überprüft werden müssen, sondern zumindest die Polarität eines Eingangs je Gleichspannungsquelle, vorzugsweise aber alle an den Eingängen anliegenden Polaritäten gleichzeitig überprüft werden, wird sowohl die Durchführung der Überprüfung als auch ihre Validität verbessert.

Die erfindungsgemäße Prüfvorrichtung weist dazu mindestens zwei elektrische Kontakte auf, die jeweils einem der Eingänge der Kombinationsschaltung zugeordnet und mit diesem verbindbar sind. Dabei sind die mindestens zwei elektrischen Kontakte Eingängen zugeordnet, die jeweils für einen der Pole von einer von mindestens zwei Gleichspannungsquellen vorgesehen sind. Damit ist mindestens einem Pol von jeder der mindestens zwei Gleichspannungsquellen ein elektrischer Kontakt der erfindungsgemäßen Prüfvorrichtung zugeordnet. Bei mehr als zwei Gleichspannungsquellen weist die Prüfvorrichtung mehr als zwei elektrische Kontakte auf. Vorzugsweise weist die Prüfvorrichtung eine der Zahl an Gleichspannungsquellen entsprechende Zahl an elektrischen Kontakten auf, sodass für mindestens einen der Pole jeder der Gleichspannungsquellen jeweils ein elektrischer Kontakt der Prüfvorrichtung vorgesehen ist, der mit dem entsprechenden Eingang der Kombinationsschaltung verbindbar ist. Es kann aber auch jedem der Eingänge jeweils ein elektrischer Kontakt zugeordnet und damit für jeden Pol jeder Gleichspannungsquelle ein elektrischer Kontakt vorgesehen sein.

Die Kombinationsschaltung kann dabei grundsätzlich beliebig ausgestaltet sein. Beispielsweise kann sie zur separaten Weiterleitung der Pole der Gleichspannungsquellen vorgesehen sein, indem jeder Eingang direkt mit einem separaten Ausgang verbunden ist. Insbesondere können durch die Kombinationsschaltung aber auch Eingänge miteinander elektrisch verbunden werden. Beispielsweise können Eingänge, an denen Spannungen mit gleicher Polarität anliegen, über eine elektrische Parallelschaltung miteinander verbunden werden, um über die Eingänge fließende Ströme an ihrem gemeinsamen Ausgang aufzuaddieren. Während des Überprüfens der Polaritäten der an die Eingänge der Kombinationsschaltung angeschlossenen Pole der Gleichspannungsquellen dürfen diese Eingänge aber (noch) nicht miteinander verbunden sein.

Wenn die Polaritäten von Spannungen, die über die zugehörigen Eingänge an den elektrischen Kontakten anliegen, jeweils mit den für die elektrischen Kontakte vorgegebenen Polaritäten übereinstimmen, d. h. wenn eine Spannung mit richtiger Polarität anliegt, wird ein Signalelement der Prüfvorrichtung mit einem elektrischen Signal zur Ausgabe eines Übereinstimmungssignals beaufschlagt. Die Ausgabe des Übereinstimmungssignals kann hierbei grundsätzlich auf beliebige Weise erfolgen. Beispielsweise kann das Übereinstimmungssignal ein optisches und/oder ein akustisches Signal sein.

Wenn die Polarität der Spannung, die an einem der elektrischen Kontakte anliegt, nicht mit der für den elektrischen Kontakt vorgegebenen Polarität übereinstimmt, d. h wenn eine Spannung mit falscher Polarität anliegt, wird das Signalelement jedoch nicht mit dem elektrischen Signal zur Ausgabe des Übereinstimmungssignals beaufschlagt. Dazu ist jeder der elektrischen Kontakte an ein Schaltelement angeschlossen, das das elektrische Signal bei fehlender Übereinstimmung zu dem Signalelement blockiert. Indem die Schaltelemente elektrisch in Reihe geschaltet sind, wird sichergestellt, dass das Signalelement mit dem elektrischen Signal zur Ausgabe des Übereinstimmungssignals nicht beaufschlagt wird, sobald auch nur an einem der elektrischen Kontakte der Prüfvorrichtung eine Spannung mit falscher Polarität anliegt.

Die für die elektrischen Kontakte der Prüfvorrichtung vorgegebenen Polaritäten können dabei grundsätzlich beliebig sein. Beispielsweise können für verschiedene elektrische Kontakte verschiedene Polaritäten vorgegeben sein. In einer besonders einfachen Ausführungsform ist die Prüfvorrichtung jedoch so ausgebildet, dass die für die elektrischen Kontakte vorgegebenen Polaritäten gleich sind. In dieser bevorzugten Ausführungsform können die für die elektrischen Kontakte vorgesehenen Schaltelemente gleichartig ausgebildet und in gleicher Weise miteinander verbunden sein.

In einer vorteilhaften Ausführungsform weist die erfindungsgemäße Prüfvorrichtung zusätzlich zu den elektrischen Kontakten weitere elektrische Kontakte auf. Während die elektrischen Kontakte den Eingängen zugeordnet sind, welche jeweils für einen der Pole von jeder Gleichspannungsquelle vorgesehen sind, sind die weiteren elektrischen Kontakte Eingängen zugeordnet und mit diesen Eingängen verbindbar, welche jeweils für den anderen der Pole jeder Gleichspannungsquelle vorgesehen sind. Damit weist die Prüfvorrichtung Paare von jeweils einem elektrischen Kontakt und einem weiteren elektrischen Kontakt auf, wobei jedes dieser Paare einem Paar von Eingängen zugeordnet ist, die für die zwei verschiedenen Pole einer Gleichspannungsquelle vorgesehen sind. Wenn im Folgenden allgemein von Kontakten die Rede ist, sind damit die elektrischen Kontakte und/oder die weiteren elektrischen Kontakte gemeint.

Als Bezugspotential, gegenüber dem die Polaritäten der Spannungen überprüft werden, welche über die zugehörigen Eingänge an den elektrischen Kontakten anliegen, kann grundsätzlich jedes elektrisches Potential vorgesehen werden. Beispielsweise kann das Bezugspotential Erde oder ein anderes extern vorgegebenes absolutes elektrisches Potential sein. Eine solche Ausführungsform der erfindungsgemäßen Prüfvorrichtung ist dann erforderlich, wenn die Polaritäten der an den elektrischen Kontakten anliegenden Spannungen konkret in Bezug auf ein solches festes oder extern vorgegebenes absolutes Potential überprüft werden sollen. In einer anderen Ausführungsform ist das Bezugspotential durch den Mittelwert von an allen elektrischen Kontakten oder den Mittelwert von an allen weiteren elektrischen Kontakten anliegenden elektrischen Potentialen bestimmt sein. Damit ändert sich zwar das Bezugspotential mit allen Änderungen der momentan anliegenden Spannungen, gerade dadurch erfolgt aber eine Anpassung des Bezugspotentials an die momentanen Potentialverhältnisse der über die Eingänge der jeweils überprüften Kombinationsschaltung an die Kontakte angeschlossenen Gleichspannungsquellen. In ähnlicher Weise passt sich das Bezugspotentials an die momentanen Potentialverhältnisse der Gleichspannungsquellen an, wenn das Bezugspotential durch den Mittelwert von allen an den Kontakten anliegenden elektrischen Potentialen mit negativer oder positiver Polarität vorgegeben ist. In einer bevorzugten Ausführungsform ist das Bezugspotential durch das an allen Kontakten anliegende niedrigste oder höchste elektrische Potential bestimmt.

In einer vorteilhaften Ausführungsform der erfindungsgemäßen Prüfvorrichtung weist die Prüfvorrichtung mindestens ein weiteres Signalelement auf, das den weiteren elektrischen Kontakten zugeordnet ist. Über das mindestens eine weitere Signalelement gibt die Prüfvorrichtung ein Fehlersignal aus, wenn über den zugeordneten Eingang an einem der weiteren elektrischen Kontakte eine Spannung mit falscher Polarität anliegt. Dazu wird das mindestens eine weitere Signalelement der Prüfvorrichtung mit einem weiteren elektrischen Signal zur Ausgabe eines Fehlersignals beaufschlagt. Durch die weiteren elektrischen Kontakte und das mindestens eine weitere Signalelement wird dann erreicht, dass gleichzeitig überprüft werden kann, ob die Prüfvorrichtung in vorgesehener Weise funktioniert und ob die Eingänge in vorgesehener Weise belegt sind. Dies liegt daran, dass nicht nur ein einzelner Eingang falsch belegt sein kann. Wenn an einem der elektrischen Kontakte eine Spannung mit falscher Polarität anliegt, liegt auch an einem der weiteren elektrischen Kontakte eine Spannung mit falscher Polarität an, nämlich an dem, der mit dem Eingang für den anderen Pol derselben Gleichspannungsquelle verbunden ist. So gibt die Prüfvorrichtung nur dann, wenn alle Eingänge richtig belegt sind, das Übereinstimmungssignal, aber kein Fehlersignal aus. Wenn hingegen auch nur eine Spannungsquelle mit vertauschten Polen an die Eingänge der Kombinationsschaltung angeschlossen ist, wird das Übereinstimmungssignal blockiert, und mindestens ein Fehlersignal wird ausgegeben. Das Vorhandensein eines der beiden Signale zeigt dabei die Funktion der Prüfvorrichtung, das genaue Signal die richtigen oder falschen Polaritäten an.

Um anzuzeigen, an welchem der weiteren elektrischen Kontakte die Polarität nicht stimmt, kann für jeden weiteren elektrischen Kontakt ein eigenes weiteres Signalelement vorgesehen sein, das bei falscher Polarität mit dem weiteren elektrischen Signal zur Ausgabe des Fehlersignals beaufschlagt ist. Die durch das Fehlersignal angezeigte falsche Polarität kann dann eindeutig einem der weiteren elektrischen Kontakte und damit einem der Eingänge zugeordnet werden. Insbesondere kann damit das Paar von Eingängen identifiziert werden, die für die beiden Pole einer Gleichspannungsquelle vorgesehen sind und die entgegen der für die Eingänge vorgegebenen Polarität mit diesen Polen verbunden sind.

Das mindestens eine weitere Signalelement kann bei falscher Polarität der Spannung, die an einem der weiteren elektrischen Kontakte anliegt, direkt über den entsprechenden weiteren elektrischen Kontakte mit einem Signal zur Ausgabe des Fehlersignals beaufschlagt sein. Es kann aber auch jeder weitere elektrische Kontakt an ein weiteres Schaltelement angeschlossen sein, das das weitere elektrische Signal bei fehlender Übereinstimmung zu dem zugehörigen weiteren Signalelement durchlässt. Beispielsweise können dabei die weiteren Schaltelemente der weiteren elektrischen Kontakte elektrisch parallel geschaltet und gemeinsam an ein einziges weiteres Signalelement angeschlossen sein. Dieses weitere Signalelement ist dann mit dem weiteren elektrischen Signal zur Ausgabe des Fehlersignals beaufschlagt, sobald an einem der weiteren elektrischen Kontakte keine Übereinstimmung vorliegt. Dabei ist aus dem Fehlersignal nicht direkt ablesbar, an welchem der weiteren elektrischen Kontakte die Übereinstimmung fehlt.

Alle Schaltelemente der erfindungsgemäßen Prüfvorrichtung können grundsätzlich beliebig ausgebildet sein. Beispielsweise können dabei Relais oder elektronische Schalter zum Einsatz kommen. In einer bevorzugten Ausführungsform sind die Schaltelemente Halbleiterschaltelemente. Beispielsweise können zur Realisierung der Halbleiterschaltelemente Transistoren, insbesondere Feldeffekttransistoren oder Bipolartransistoren, dienen.

Die Halbleiterschaltelemente können als selbstleitende Halbleiterschaltelemente ausgebildet sein. Bevorzugt sind die Halbleiterschaltelemente jedoch selbstsperrend, sodass die Halbleiterschaltelemente nur dann ein elektrisches Signal durchlassen, wenn an dem zugehörigen elektrischen Kontakt eine Spannung mit der richtigen Polarität anliegt.

Jedes Haltleiterschaltelement kann einen auf dem Bezugspotential liegenden Bezugseingang und einen Steuereingang aufweisen, an dem eine Spannung mit der gleichen Polarität wie an dem zugehörigen elektrischen Kontakt anliegt. Dadurch ist das Halbleiterschaltelement in Abhängigkeit von der Polarität der an dem zugehörigen elektrischen Kontakt anliegenden Spannung gegenüber dem Bezugspotential steuerbar. Das Halbleiterschaltelement kann dabei so ausgebildet sein, dass das Halbleiterschaltelement das elektrische oder das weitere elektrische Signal bei einer positiven Polarität gegenüber dem Bezugspotential durchlässt, wohingegen die elektrischen Signale bei einer negativen Polarität gegenüber dem Bezugspotential blockiert sind. Das Halbleiterschaltelement kann aber auch in umgekehrter Weise funktionieren.

In einer bevorzugten Ausführungsform ist jedes Halbleiterschaltelement derart ausgebildet, dass es blockiert, wenn das Bezugspotential an seinem Steuereingang anliegt, und dass es ein elektrisches Signal nur dann durchlässt, wenn die Spannung an seinem Steuereingang in vorgegebener Weise von dem Bezugspotential abweicht, d. h. die für einen der elektrischen Kontakte richtige Polarität aufweist. Wenn die Spannung an dem Steuereingang hingegen nicht oder mit der entgegen gesetzten Polarität von dem Bezugspotential abweicht, sperrt das Halbleiterschaltelement. Bei den weiteren elektrischen Kontakten ist aber gerade dies die richtige Polarität, und sie soll auch zum Sperren der Halbleiterschaltelemente führen. Das weitere elektrische Signal soll nur dann durchgelassen werden, wenn an dem Steuereingang eine Spannung mit der für die weiteren elektrischen Kontakte falschen Polarität anliegt.

Bevorzugt ist in dieser Ausführungsform der Prüfvorrichtung jedem Halbleiterschaltelement eine Diode zugeordnet, die elektrisch zwischen den Bezugseingang und den Steuereingang geschaltet ist. Dadurch wird erreicht, dass - je nach Durchlassrichtung der parallel geschalteten Dioden - die negativen oder die positiven Pole aller Gleichspannungsquellen in die Nähe des Bezugspotential gebracht werden und damit das jeweilige Halbleiterschaltelement definiert sperren. Die andersnamigen Pole der Gleichspannungsquellen sorgen hingegen sicher dafür, dass die Schaltelemente ein elektrisches Signal durchlassen.

Zusätzlich zu der einen Diode zwischen dem Bezugseingang und dem Steuereingang ist jedem Halbleiterschaltelement vorzugsweise eine weitere, in gleicher Durchlassrichtung ausgerichtete Diode zugeordnet, die elektrisch zwischen den Steuereingang und einen gemeinsamen Ausgang der in Reihe geschalteten Halbleiterschaltelemente geschaltet ist. Die zweiten Dioden stellen an dem gemeinsamen Ausgang eine Spannung für das Hervorrufen der elektrischen Signale in der Prüfvorrichtung bereit.

Durch die beiden jedem Halbleiterschaltelement zugeordneten Dioden wird somit zum einen ein besonders stabiles Schaltverhalten des Halbleiterschaltelements und ein besonders stabiles Ausgabeverhalten des Fehlersignals und/oder des Übereinstimmungssignals erreicht. Insbesondere wird vermieden, dass zu hohe Spannungen an den Steuereingängen der Halbleiterschaltelemente anliegen, wenn die Halbleiterschaltelemente das jeweilige elektrische Signal blockieren. Zum anderen bewirken die beiden Dioden eine Gleichrichtung unabhängig von der Polarität der an den einzelnen elektrischen Kontakten und weiteren elektrischen Kontakten anliegenden Spannungen, um daraus eine Spannungsversorgung für die Prüfvorrichtung abzuleiten. Darüber hinaus bewirkt die Gleichrichtung, dass eine bestimmte Stromrichtung vorgegeben wird und damit bestimmte Potentiale an den den elektrischen Kontakten abgewandten Seiten der Dioden anliegen, die den Potentialen an den elektrischen Kontakten mit der richtigen Polarität (abzüglich einer Durchlassspannung der jeweiligen Dioden) entsprechen und die in besonders einfacher Weise als Bezugspotentiale genutzt werden können.

In einer vorteilhaften Ausführungsform der erfindungsgemäßen Prüfvorrichtung sind Schaltstellungen aller Schaltelemente, in denen sie das elektrische Signal und/oder das weitere elektrische Signal durchlassen oder blockieren und die sie einnehmen, ohne dass an den ihnen zugeordneten elektrischen Kontakten eine externe Spannung anliegt, einstellbar. Mit einer solchen externen Spannung ist insbesondere die Spannung gemeint, die über den an den jeweils zugehörigen Eingang angeschlossenen Pol der zugehörigen Gleichspannungsquelle anliegt. Dadurch kann die Schaltstellung von Schaltelementen, an deren zugeordneten elektrischen Kontakten keine Spannung anliegt, beispielsweise weil diese nicht mit einem der Eingänge für einen Pol einer der Gleichspannungsquellen verbunden sind, gezielt vorgegeben werden.

Die Schaltstellung der Schaltelemente und/oder weiteren Schaltelemente der Prüfvorrichtung ohne externe Spannungen an den zugehörigen Kontakten kann auch fest vorgegeben werden.

Bevorzugt wird dazu an jeden der Kontakte, an denen keine Spannung anliegt, weil an die zugehörigen Eingänge keine Pole der Gleichspannungsquellen angeschlossen sind, eine Spannung mit der jeweils richtigen Polarität angelegt. So können auch dann, wenn nur an einzelnen Kontakten Spannungen anliegen, die durch an die zugehörigen Eingänge angeschlossene Pole der Gleichspannungsquellen vorgegeben sind, deren Polaritäten gegenüber dem Bezugspotential überprüft werden.

In einer weiteren Ausführungsform wird an jeden der Kontakte, an denen keine Spannung anliegt, obwohl an die zugehörigen Eingänge eine Spannungsquelle angeschlossen sein sollte, eine Spannung mit der jeweils falschen Polarität angelegt. Dadurch wird sichergestellt, dass die Prüfvorrichtung solange ein Fehlersignal und/oder kein Übereinstimmungssignal ausgibt, bis an jedem dieser Kontakte überhaupt eine externe Spannung anliegt, die zudem die richtige Polarität aufweist. Damit wird auch garantiert, dass die Kontakte der Prüfvorrichtung tatsächlich mit den zu überprüfenden Eingängen der Kombinationsschaltung elektrisch verbunden sind.

Um die Schaltstellungen der Schaltelemente zwar gezielt, aber veränderbar vorgeben zu können, können den Schaltelementen Wechselschalter zugeordnet werden, mit denen zwischen der Vorgabe einer Spannung mit der jeweils richtigen und einer Spannung mit der jeweils falschen Polarität an dem jeweiligen Steueranschluss umgeschaltet werden kann. In einer vorteilhaften Ausgestaltung schaltet jeder Wechselschalter die Polaritäten der an den Steueranschlüssen von zwei Schaltelementen ohne externe Spannung anliegenden Spannungen um. Diese beiden Schaltelemente sind den beiden Kontakten bzw. Eingängen für die beiden Pole einer Gleichspannungsquelle zugeordnet. So kann mit dem einen Wechselschalter vorgegeben werden, ob an diesen beiden Kontakten externe Spannungen anliegen müssen oder nicht, um die Anzeige eines Anschlussfehlers zu vermeiden.

Das Signalelement oder die Signalelemente der erfindungsgemäßen Prüfvorrichtung geben in einer bevorzugten Ausführungsform ein optisches Signal oder optische Signale aus. Dabei kann jedes Signalelement als Leuchtdiode ausgeführt sein, da Leuchtdioden direkt mit dem elektrischen Signal bzw. dem mindestens einen weiteren elektrischen Signal beaufschlagt werden können und sich durch eine lange Lebensdauer und einer geringen Leistungsaufnahme auszeichnen. Um das Übereinstimmungssignal und das Fehlersignal optisch unterscheidbar zu gestalten, kann das Signalelement, das das Übereinstimmungssignal ausgibt, beispielsweise eine grüne Leuchtdiode sein, wohingegen das mindestens eine Signalelement, das das Fehlersignal ausgibt, beispielsweise eine rote Leuchtdiode sein kann. Es sind aber auch beliebige andere Ausführungen und Farbkombinationen möglich. Beispielsweise kann ein von dem Signalelement ausgesendetes optisches Signal zeitlich moduliert sein, um ein Fehlersignal anzuzeigen, wohingegen das ausgesendete optische Signal im Wesentlichen konstant ist, wenn eine Übereinstimmung angezeigt werden soll.

Um für jedes Signalelement eine Versorgung mit elektrischer Energie bereitzustellen, kann die erfindungsgemäße Prüfvorrichtung einen Energiespeicher aufweisen, um das elektrische Signal und alle weiteren elektrischen Signale bereitzustellen. Über den Energiespeicher können dann auch Signalelemente versorgt werden, die zusätzliche elektrische Energie neben dem jeweiligen elektrischen Signal oder weiteren elektrischen Signal benötigen.

Der Energiespeicher kann dazu als externer Energiespeicher, wie beispielsweise als Batterie, ausgebildet sein. Der Energiespeicher kann aber auch durch die an den elektrischen Kontakten anliegenden Spannungen bereitgestellt werden. In einer bevorzugten Ausführungsform ist der Energiespeicher ein mittels an den elektrischen Kontakten anliegenden Spannungen aufladbarer Kondensator. Durch eine zu dem Kondensator elektrisch parallel geschaltete, spannungsbegrenzende Diode kann dabei verhindert werden, dass zu hohe Spannungen an dem Signalelement oder den Signalelementen anliegen. Wenn der Kondensator an den gemeinsamen Ausgang der in Reihe geschalteten Halbleiterschaltelemente angeschlossen ist, der mit den Kontakten der Prüfvorrichtung über parallele Dioden verbunden ist, dienen diese Dioden als Gleichrichter für eine definierte Aufladung der Kondensators (siehe oben).

Zusätzlich kann in der Prüfvorrichtung ein Strombegrenzer für das Signalelement und/oder die weiteren Signalelemente vorgesehen sein. Ein solcher Strombegrenzer ist beispielsweise aus einem Transistor und einem in Reihe dazu geschalteten elektrischen Widerstand aufgebaut. Indem der Strombegrenzer zwischen dem Energiespeicher und dem Signalelement und/oder den weiteren Signalelementen angeordnet wird, werden diese gleichmäßig mit elektrischer Energie beaufschlagt. Während beispielsweise bereits mit einem einfachen Widerstand als Strombegrenzer ein unerwünschtes "Flackern" der LEDs verhindert wird, kann mit Hilfe der Reihenschaltung aus Widerstand und Transistor eine weitgehend gleichmäßige Leuchtkraft der LEDs erreicht werden, solange der Energiespeicher ausreichend geladen ist.

Außerdem kann ein Schalter vorgesehen sein, der betätigt werden muss, damit die Prüfvorrichtung das Übereinstimmungs- oder Fehlersignals ausgibt. Dazu kann der Schalter zwischen den Energiespeicher und das Signalelement und/oder das weitere Signalelement geschaltet sein. Dadurch kann sich der Energiespeicher nur dann über das Signalelement und/oder die weiteren Signalelemente entladen, wenn tatsächlich eine Überprüfung vorgenommen werden soll, und ein unnötiges Entladen des Energiespeichers wird verhindert. Der Schalter kann von einem Benutzer der Prüfvorrichtung manuell betätigbar sein.

Die Prüfvorrichtung kann mit der Kombinationsschaltung bzw. deren Eingängen fest verbunden sein. In einer bevorzugten Ausführungsform ist die Prüfvorrichtung jedoch als Handgerät mit einem Gehäuse und einer Anschlussleiste ausgebildet, wobei über die Anschlussleiste die Eingänge der Kombinationsschaltung in fester Zuordnung mit den elektrischen Kontakten verbindbar sind. Die Prüfvorrichtung kann so an verschiedenen Kombinationsschaltungen eingesetzt werden, um zu überprüfen, dass die Pole angeschlossener Gleichspannungsquellen richtige Polaritäten aufweisen.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Wenn hingegen nur die genaue Anzahl eines Merkmals angegeben werden soll, findet das Adjektiv "genau" vor dem jeweiligen Merkmal Verwendung. Diese Merkmale können durch andere Merkmale ergänzt werden oder die einzigen Merkmale sein, aus denen das jeweilige Erzeugnis besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: zeigt eine Ausführungsform einer erfindungsgemäßen Prüfvorrichtung in schematischer Darstellung.
- **Fig. 2**: zeigt eine Ausführungsform einer erfindungsgemäßen Prüfvorrichtung, die neben einem Signalelement für ein Übereinstimmungssignal ein weiteres Signalelement für ein Fehlersignal aufweist.
- **Fig. 3**: zeigt eine weitere Ausführungsform einer erfindungsgemäßen Prüfvorrichtung, die neben dem Signalelement für das Übereinstimmungssignal mehrere weitere Signalelemente für das Fehlersignal aufweist.
- **Fig. 4**: zeigt eine Variante der erfindungsgemäßen Prüfvorrichtung gemäß Fig. 3, die zusätzlich mit Wechselschaltern ausgestattet ist.

### FIGURENBESCHREIBUNG

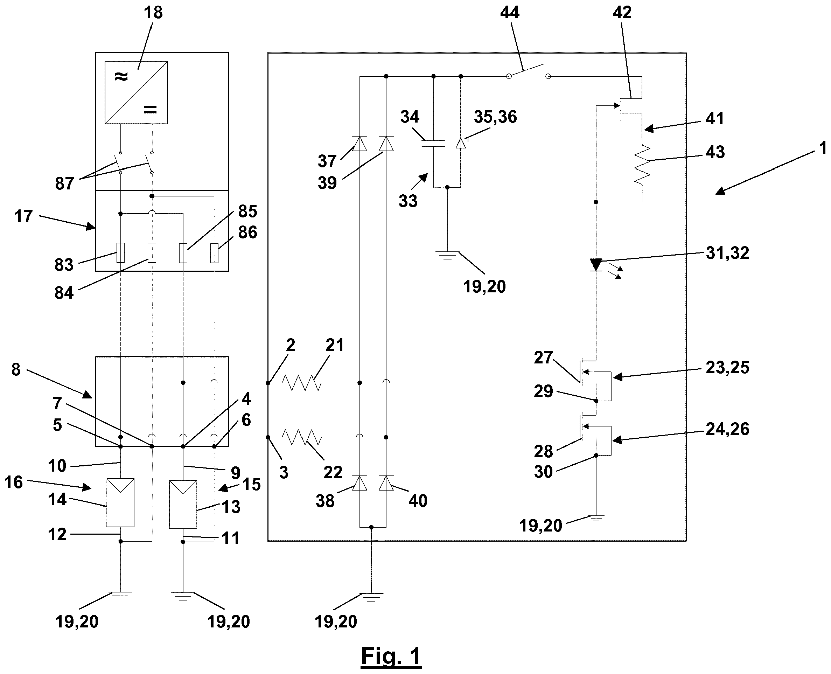

**Fig. 1** zeigt eine erfindungsgemäße Prüfvorrichtung 1 mit zwei elektrischen Kontakten 2, 3, die mit jeweils einem Eingang 4, 5 von insgesamt vier Eingängen 4 bis 7 einer Kombinationsschaltung 8 elektrisch leitend verbunden sind. An jedem der Eingänge 4 bis 7 der Kombinationsschaltung 8 ist jeweils ein Pol 9 bis 12 von zwei Gleichspannungsquellen 13, 14 angeschlossen.

In der hier dargestellten Ausführung sind die Gleichspannungsquellen 13, 14 mit den Polen 9 bis 12 separate Strings 15, 16 eines Photovoltaikgenerators, die hier in der Kombinationsschaltung 8, beispielsweise einem gemeinsamen Anschlussstecker, zusammengeführt sind. In einer hier separaten Zusammenführungsschaltung 17 werden die gleichnamigen Pole 9 und 10 bzw. 11 und 12 der Gleichspannungsquellen 13, 14 zusammengefasst, sodass die von den einzelnen Strings 15, 16 generierten Gleichströme aufaddiert werden. Die aufaddierten Gleichströme werden einem Wechselrichter 18 zugeführt, der sie in einen Wechselstrom umwandelt. In Fig. 1 ist unterstellt, dass die positiven Pole 9 und 10 der Gleichspannungsquellen 13, 14, für die die Eingänge 4, 5 vorgesehen sind, eine definierte positive Polarität gegenüber Erde 20, die hier als Bezugspotential dient, aufweisen, weil beispielsweise die negativen Polen 11 und 12 oder auch Mittelpunkte der Gleichspannungsquellen geerdet sind. Mit der Prüfvorrichtung 1 kann nun überprüft werden, ob jeder der Pole 9 bis 12 die Polarität gegenüber dem Bezugspotential 19 aufweist, für die der jeweilige Eingang 4 bis 7 der Kombinationsschaltung 8 vorgesehen ist. Dazu werden die Eingänge 4, 5, an die die positiven Pole 9 und 10 der Gleichspannungsquellen 13, 14 angeschlossen sein sollten, mit den elektrischen Kontakten 2, 3 der Prüfvorrichtung 1 elektrisch leitend verbunden. Dies geschieht bevor die Kombinationsschaltung 8 mit der Zusammenführungsschaltung 17 verbunden wird, d. h. bevor irgendwelche der Pole 9 bis 12 bereits elektrisch miteinander verbunden sind. Die Zwischenschaltung 17 weist hierfür jeden Eingang 4 bis 7 eine Sicherung 83 bis 86 auf. Diese können zum Schutz vor einem Überstrom dienen, der bei einer Verbindung der Eingänge 4 und 5 bzw. 6 und 7 in der Zwischenschaltung 17 zwischen diesen Eingängen auftreten kann. Die durch die Zusammenführungsschaltung 17 zusammengeführten Eingänge 4 und 5 bzw. 6 und 7 werden durch einen allpoligen Schalter 87 mit dem Wechselrichter 18 verbunden.

Die beiden elektrischen Kontakte 2, 3 der Prüfvorrichtung 1 sind jeweils über einen Eingangswiderstand 21 bzw. 22 mit einem Steuereingang 27 bzw. 28 eines Schaltelements 23 bzw. 24 elektrisch leitend verbunden. Die Schaltstellungen der Schaltelemente 23, 24, die hier Halbleiterschaltelemente 25, 26 sind, hängen von der Polarität der an den elektrischen Kontakten 2, 3 anliegenden Spannungen gegenüber dem Bezugspotential 19 ab. Die Schaltelemente 23, 24 sind bei der in Fig. 1 dargestellten Prüfvorrichtung 1 so ausgeführt und verschaltet, dass sie ein elektrisches Signal solange blockieren, wie die Polarität der an ihrem Steuereingang 27, 28 anliegende Spannung gegenüber dem an ihrem Bezugseingang 29, 30 anliegenden Bezugspotential 19 nicht positiv ist. Die Schaltelemente 23, 24 sind dabei elektrisch in Reihe geschaltet, sodass ein elektrisches Signal blockiert wird, sobald die Polarität einer der beiden Spannungen, die über die zugeordneten Eingänge 4, 5 an den zwei elektrischen Kontakten 2, 3 anliegen, nicht positiv ist. In der hier dargestellten Ausführung wird das elektrische Signal demnach solange blockiert, wie an einem oder beiden der elektrischen Kontakte 2, 3 keine externe Spannung oder eine externe Spannung anliegt, die keine positive Polarität relativ zu dem Bezugspotential 19 aufweist.

Durch das Blockieren des elektrischen Signals durch die Schaltelemente 23, 24 wird erreicht, dass bei falscher Polarität der an den elektrischen Kontakten 2, 3 anliegenden Spannungen ein Stromfluss durch ein Signalelement 31 unterbrochen ist und dieses kein Übereinstimmungssignal ausgibt. Liegen an den elektrischen Kontakten 2, 3 jedoch Spannungen mit positiver Polarität an, wird das Signalelement 31 mit einem elektrischen Signal zur Ausgabe des Übereinstimmungssignals beaufschlagt. In der hier dargestellten Ausführung bedeutet dies, dass dann, wenn an beiden elektrischen Kontakten 2, 3 eine Spannung positiver Polarität gegenüber dem Bezugspotential 19 anliegt, der Stromkreis über das Signalelement 31 geschlossen ist. Das Signalelement 31 ist hierbei als eine LED 32 ausgeführt und das Übereinstimmungssignal ist ein optisches Signal, das die LED 32 aussendet, wenn sie mit dem von den Schaltelementen 23, 24 freigegebenen elektrischen Signal zur Ausgabe des Übereinstimmungssignals, hier einem elektrischen Strom, beaufschlagt ist.

Zur elektrischen Versorgung des Signalelements 31 weist die hier dargestellte Prüfvorrichtung 1 einen Energiespeicher 33 auf. Dieser ist durch einen Kondensator 34 mit einer parallel geschalteten spannungsbegrenzenden Diode 35, wie einer Zener-Diode 36, gebildet. Der Kondensator 34 wird über die an den elektrischen Kontakten 2, 3 anliegenden Spannungen gegenüber dem Bezugspotential 19 aufgeladen. Der Kondensator 34 entlädt sich über die elektrischen Kontakte 2, 3 jedoch auch dann nicht, wenn dort keine Spannungen mit positiver Polarität gegenüber dem Bezugspotential 19 anliegen. Dazu ist jedem elektrischen Kontakt 2, 3 eine Diode 37 bzw. 39 zugeordnet, deren Durchlassrichtungen ein Aufladen des Kondensators 34 zulassen, jedoch ein Entladen des Kondensators über die elektrischen Kontakte 2, 3 verhindern. Durch je eine weitere Diode 38 bzw. 40 je Kontakt 2, 3 wird erreicht, dass die elektrischen Potentiale der Kontakte 2, 3, wenn Spannungen mit grundsätzlich negativer Polarität gegenüber dem Bezugspotential 19 anliegen, in die Nähe des Bezugspotentials gezogen werden. Damit liegen die Steuereingänge 27, 28 der Schaltelemente 23, 24 auf demselben elektrischen Potential wie ihre Bezugseingänge 29, 30, sodass sie das elektrische Signal blockieren.

Um den Strom von dem Kondensator 34 des Energiespeichers 33 durch das Signalelement 31 zu begrenzen, wenn an den elektrischen Kontakten 2, 3 jeweils eine Spannung positiver Polarität anliegt, ist in der in Fig. 1 dargestellten Ausführung der Prüfvorrichtung 1 ein Strombegrenzer 41 vorgesehen. Dadurch kann beispielsweise ein "Flackern" der LED 32 verhindert werden und eine weitgehend gleichmäßige Leuchtstärke der LEDs erzielt werden. Der Strombegrenzer 41 ist hier aus einem Transistor 42 und einem Widerstand 43 gebildet. Zusätzlich weist die in Fig. 1 dargestellte Prüfvorrichtung 1 einen Schalter 44 auf, der zur Inbetriebnahme der Prüfvorrichtung 1 zu schließen ist. Der Schalter 44 ist hier zwischen den Energiespeicher 44 und den Strombegrenzer 41 geschaltet. Solange der Schalter 44 nicht geschlossen ist, d. h. wenn die Prüfvorrichtung 1 nicht in Betrieb ist, ist der Stromkreis unterbrochen, über den das elektrische Signal zu dem Signalelement 31 geführt werden kann. In den voranstehenden Erläuterungen des Betriebs der Prüfvorrichtung 1 ist entsprechend unterstellt, dass der Schalter 44 - anders als in Fig. 1 dargestellt - geschlossen ist.

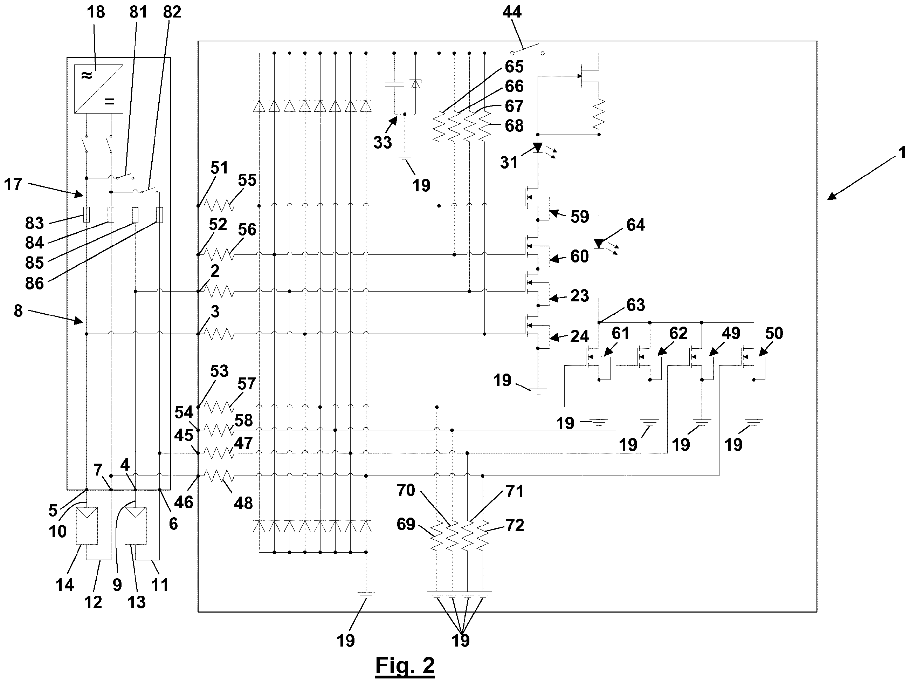

**Fig. 2** zeigt eine Ausführungsform einer erfindungsgemäßen Prüfvorrichtung 1, die neben den zwei elektrischen Kontakten 2, 3 weitere elektrische Kontakte 45, 46 aufweist, die den Eingängen 6, 7 der Kombinationsschaltung 8 zugeordnet sind, an die jeweils der andere Pol 11, 12 der Gleichspannungsquellen 13, 14 angeschlossen ist. Die Kombinationsschaltung 8 und die Zusammenführungsschaltung 17 sind hier Teile des Wechselrichters 18. Dabei weist die Zusammenführungsschaltung 18 Zusammenführungsschalter 81 und 82 auf, die die gleichnamigen Pole 9 und 10 bzw. 11 und 12 der Gleichspannungsquellen 3, 4 miteinander verbinden, aber während des Betriebs der Prüfvorrichtung 1 geöffnet sind. Den zwei weiteren elektrischen Kontakten 45, 46 sind jeweils weitere Eingangswiderstände 47, 48 sowie weitere Schaltelemente 49, 50 zugeordnet. Neben den elektrischen Kontakten 2, 3 und den weiteren elektrischen Kontakten 45, 46 weist die in Fig. 2 dargestellten Prüfvorrichtung 1 zusätzliche elektrische Kontakte 51, 52 sowie zusätzliche weitere elektrische Kontakte 53, 54 auf. Diese sind für eventuelle weitere Eingänge der Kombinationsschaltung 8 vorgesehen, an die Pole weiterer Gleichspannungsquellen angeschlossen werden können. Den elektrischen Kontakten 51, 52 sowie den weiteren elektrischen Kontakten 53, 54 sind ebenfalls Eingangswiderstände 55 bis 58 sowie Schaltelemente 59 bis 62 zugeordnet. Dabei sind die Schaltelemente 23, 24, 59, 60 der elektrischen Kontakte 2, 3, 51, 52 elektrisch in Reihe geschaltet, wohingegen die weiteren Schaltelemente 49, 50, 61, 62 der weiteren elektrischen Kontakte 45, 46, 53, 54 elektrisch parallel geschaltet sind.

Die parallel geschalteten weiteren Schaltelemente 49, 50, 61, 62 sind über ihren gemeinsamen Ausgang 63 mit einem weiteren Signalelement 64 verbunden, das mit einem elektrischen Signal zur Ausgabe eines Fehlersignals beaufschlagt ist, sobald eines der weiteren Schaltelemente 49, 50, 61, 62 in Durchlassrichtung geschaltet ist. Solch eine Schaltstellung, in der das weitere elektrische Signal zur Ausgabe des Fehlersignals an das weitere Signalelement 64 weitergegeben wird, wird erreicht, wenn an einem der weiteren elektrischen Kontakte 45, 46, 53, 54 eine Spannung falscher Polarität anliegt. Das weitere elektrische Signal wird jedoch durch die weiteren Schaltelemente 49, 50, 61, 62 blockiert, wenn die Polaritäten der Spannungen an den weiteren elektrischen Kontakten 45, 46, 53, 54 mit den jeweils vorgegebenen Polaritäten übereinstimmen.

Das weitere Signalelement 64 wird wie das Signalelement 31 über den Energiespeicher 33 mit elektrischer Energie versorgt. Der Energiespeicher 33 ist dazu ähnlich wie in Fig. 1 ausgeführt, wobei hier allen elektrischen Kontakten 2, 3, 51, 52 und 45, 46, 53, 54 jeweils zwei Dioden zugeordnet sind, von denen jeweils eine zur Gleichrichtung vorgesehen ist. Durch die andere wird das an einem der Steuereingänge der Schaltelemente 23, 24, 49, 50, 59 bis 62 anliegende Potential in die Nähe des Bezugspotentials 19 gebracht, wenn die Polarität der Spannung des entsprechenden elektrischen Kontakts 2, 3, 51, 52 oder des entsprechenden weiteren elektrischen Kontakts 45, 46, 53, 54 grundsätzlich negativ ist.

Jedem der elektrischen Kontakte 2, 3, 51, 52 und der weiteren elektrischen Kontakte 45, 46, 53, 54 der Prüfvorrichtung 1 ist ein elektrischer Widerstand 65 bis 72 zugeordnet. Über diese Widerstände 65 bis 72 wird ein definierter Schaltzustand der Schaltelemente 23, 24, 49, 50, 59 bis 62 eingestellt, wenn an den zugehörigen elektrischen Kontakten 2, 3, 51, 52 sowie den weiteren elektrischen Kontakten 45, 46, 53, 54 keine Spannung von extern anliegt, weil diese nicht mit Eingängen verbunden sind, an denen ein Pol einer Gleichspannungsquelle angeschlossen ist. In der in Fig. 2 dargestellt Ausführung wird dazu an die elektrischen Kontakte 51, 52 sowie den weiteren elektrischen Kontakten 53, 54, die nicht mit Eingängen der Kombinationsschaltung 8 verbunden sind, jeweils eine Spannung mit der jeweils richtigen Polarität angelegt. Für die in Fig. 2 dargestellte Ausführung bedeutet dies, dass an dem Steuereingang der Schaltelemente 59 und 60 eine Spannung mit positiver Polarität gegenüber dem Bezugspotential 19 anliegt, sodass die beiden Schaltelemente das elektrische Signal zur Ausgabe des Übereinstimmungssignals zu dem Signalelement 31 weiterleiten. An den Steuereingängen der weiteren Schaltelemente 61 und 62 hingegen liegt ein Potential nahe dem Bezugspotential 19 an, sodass die Schaltelemente 61, 62 das weitere elektrische Signal zur Ausgabe des Fehlersignals zu dem weiteren Signalelement 64 hin blockieren. Damit wird die Funktion der Prüfvorrichtung 1 nicht dadurch gestört, dass ein Teil der elektrischen Kontakte 2, 3, 51, 52 oder der weiteren elektrischen Kontakte 45, 46, 53, 54 nicht mit einem der Eingänge 4 bis 7 der Kombinationsschaltung 8 verbunden ist.

Ein Vorteil der in Fig. 2 dargestellten Prüfvorrichtung 1 ist, dass gleich erkannt werden kann, dass die Prüfvorrichtung 1 betriebsbereit und funktionstüchtig ist. Dann wird nämlich entweder das Übereinstimmungssignal (Fall a) oder das Fehlersignal (Fall b) ausgegeben, aber es wird nicht keines der Signale ausgegeben. Dies wird folgendermaßen erreicht:
Fall a: Wenn keine der an den weiteren elektrischen Kontakten 45, 46, 53, 52 anliegenden Spannungen eine positive Polarität gegenüber dem Bezugspotential 19 aufweist, wird zwar nicht das weitere Signalelement 64 mit dem weiteren elektrischen Signal zur Ausgabe des Fehlersignals beaufschlagt. In diesem Fall ist aber das Signalelement 31 mit dem elektrischen Signal zur Ausgabe des Übereinstimmungssignals beaufschlagt, da dann die Polaritäten aller an den elektrischen Kontakten 2, 3, 51, 52 anliegenden Spannungen positiv sind. Damit geben alle der in Reihe geschalteten Schaltelemente 23, 24, 59, 60 das elektrische Signal zur Ausgabe des Übereinstimmungssignals zu dem Signalelement 31 weiter. Damit wird in diesem Fall insgesamt nur das Übereinstimmungssignal ausgegeben.
Fall b: Wenn auch nur an einem der elektrischen Kontakte 2, 3, 51, 52 eine Spannung negativer Polarität anliegt, sperrt das zugehörige Schaltelement 23, 24, 59, 60 mit der Folge, dass das Signalelement 31 kein Übereinstimmungssignal ausgibt. In diesem Fall liegt aber auch an mindestens einem der weiteren elektrischen Kontakte 45, 46, 53, 52 eine Spannung mit falscher Polarität, d.h. positiver Polarität, an. Dementsprechend wird das weitere elektrische Signal nicht mehr durch alle weiteren Schaltelemente 49, 50, 61, 62 blockiert, sondern durch mindestens eines durchgelassen. Somit wird aber auch das weitere Signalelement 64 mit dem weiteren elektrischen Signal beaufschlagt und gibt das Fehlersignal aus. Damit wird in diesem Fall insgesamt nur das Fehlersignal ausgegeben.

Indem also mindestens das Signalelement 31 das Übereinstimmungssignal oder das weitere Signalelement 64 das Fehlersignal ausgibt, kann bei der in Fig. 2 dargestellten Ausführung der Prüfvorrichtung 1 erkannt werden, dass die Prüfvorrichtung 1 betriebsbereit und funktionstüchtig ist. Wenn keines der beiden Signale ausgegeben wird, wird damit angezeigt, dass die Prüfvorrichtung 1 nicht betriebsbereit ist. Damit ist auch der Fall umfasst, dass an keinem der Kontakte 2, 3, 51, 52 und 45, 46, 53, 52 eine Spannung anliegt.

Ein weiterer Vorteil der in Fig. 2 dargestellten Ausführung ist, dass mit der Prüfvorrichtung 1 die Pole 9 bis 12 von den Gleichspannungsquellen 13, 14 überprüfbar sind, ohne dass die Gleichspannungsquelle geerdet sein muss. Dies wird insbesondere durch die Diodegleichrichtung und die weiteren elektrischen Kontakte 45, 46 erreicht, die mit den Eingängen 6, 7 für die negativen Pole 11, 12 verbunden sind.

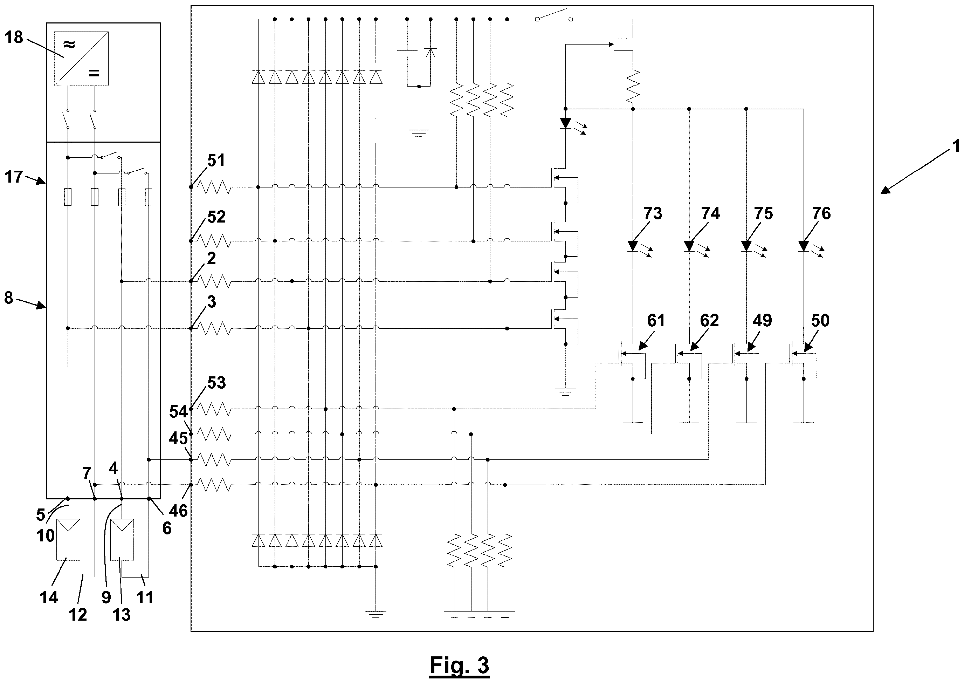

**Fig. 3** zeigt eine weitere Ausführungsform der erfindungsgemäßen Prüfvorrichtung 1 ähnlich zu der in Fig. 2 dargestellten Ausführung. In der in Fig. 3 gezeigten Ausführung ist jedoch jedem der weiteren Schaltelemente 49, 50, 61, 62 jeweils ein weiteres Signalelement 73 bis 76 zugeordnet, sodass für jeden der weiteren elektrischen Kontakte 45, 46, 53, 54 separat angezeigt wird, wenn an dem weiteren elektrischen Kontakt eine Spannung mit falscher Polarität anliegt. In dieser Ausführung der erfindungsgemäßen Prüfvorrichtung 1 kann damit in besonders einfacher Weise abgelesen werden, wenn an einem der mit den elektrischen Kontakten 2, 3, 51, 52 oder weiteren elektrischen Kontakten 45, 46, 53, 54 verbundenen Eingängen 4 bis 7 ein Pol 9 bis 12 der Gleichspannungsquellen 13, 14 mit falscher Polarität angeschlossen ist. Zudem ist in Fig. 3 zwar die Kombinationsschaltung 8 mit der Zusammenführungsschaltung 17, nicht aber auch mit dem Wechselrichter 18 in eine Einrichtung kombiniert. Der Wechselrichter kann so auch entfernt von einer oder mehreren solchen Kombinationsschaltungen 8 angeordnet sein.

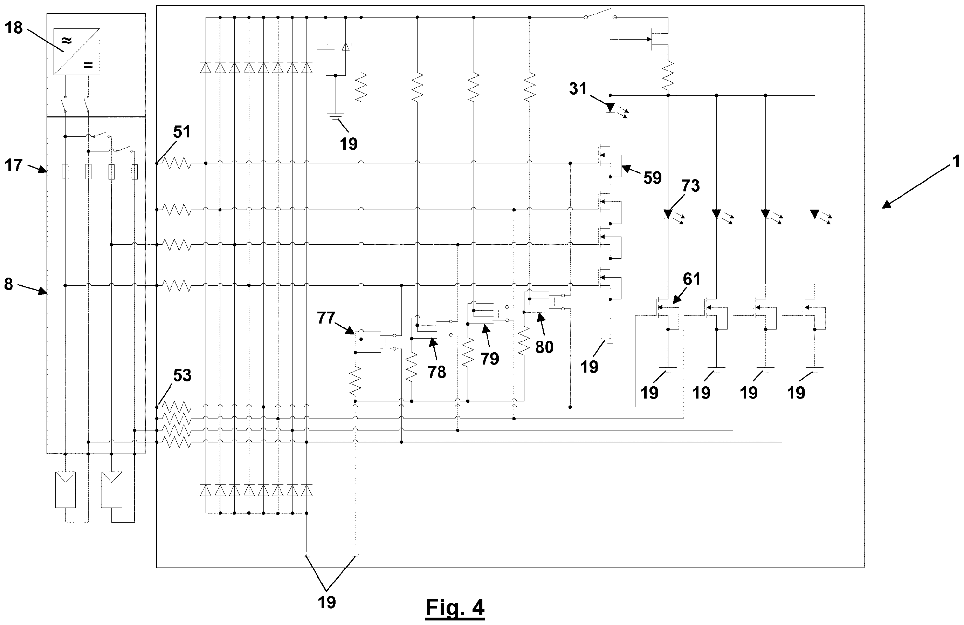

In **Fig. 4** ist eine Prüfvorrichtung 1 ähnlich zu der in Fig. 3 dargestellten Ausführung gezeigt. Allerdings ist in der in Fig. 4 dargestellten Ausführung jedem Paar aus einem elektrischen Kontakt 2, 3, 51, 52 und dem zugehörigen weiteren elektrischen Kontakt 45, 46, 53, 54 ein Wechselschalter 77 bis 80 zugeordnet. Beispielsweise ist der Wechselschalter 80 dem elektrischen Kontakt 51 und dem weiteren elektrischen Kontakt 53 zugeordnet. Über den Wechselschalter 80 kann nun je nach Schaltstellung des Wechselschalters 80 dem elektrischen Kontakt 51, solange keine externe Spannung anliegt, ein Potential nahe dem Bezugspotential 19 zugeordnet werden, sodass das zugehörige, in Reihe geschaltete Schalelement 59 das elektrische Signal zur Ausgabe des Übereinstimmungssignals zu dem Signalelement 31 blockiert. Gleichzeitig wird dann durch den Wechselschalter 80 dem weiteren elektrischen Kontakt 53, solange keine externe Spannung anliegt, eine Spannung mit positiver Polarität zugeordnet, die also nicht mit der für den weiteren elektrischen Kontakt 53 vorgegebenen Polarität übereinstimmt. Somit gibt das zugehörige weitere Schaltelement 61 das weitere elektrische Signal zur Ausgabe des Fehlersignals weiter und das zugehörige weitere Signalelement 73 ist mit dem weiteren elektrischen Signal beaufschlagt.

Der Wechselschalter 80 wird in diese Schaltstellung gebracht, wenn an den Kontakten 51 und 53 externe Spannungen anliegen müssten, weil sie Eingängen der Kombinationsschaltung zugeordnet sind, die belegt sein sollten. Dann müssen der elektrische Kontakt 51 und der weitere elektrische Kontakt 53 mit Eingängen verbunden werden, an denen Pole der jeweils vorgegebenen Polarität einer Gleichspannungsquelle angeschlossen sind, damit sich die Schaltstellung des Schaltelements 59 derart ändert, dass dieses das elektrische Signal zur Ausgabe des Übereinstimmungssignals zu dem Signalelement 31 weitergibt. Gleichzeitig ändert sich die Schaltstellung des weiteren Schaltelements 61 so, dass das weitere elektrische Signal zur Ausgabe des Fehlersignals zu dem zugehörigen weiteren Signalelement 73 blockiert ist. Bei dieser Ausführung der Prüfvorrichtung 1 wird also sichergestellt, dass die Prüfvorrichtung 1 so lange kein Übereinstimmungssignal, sondern ein Fehlersignal ausgibt, bis an jedem der elektrischen Kontakte 2, 3, 51, 52 und 45, 46, 53, 54, die mit Eingängen 4 bis 7 verbunden sein sollten, an welchen eine Spannungsquelle angeschlossen sein sollte, tatsächlich eine Spannung mit der jeweils richtigen Polarität anliegt. In der in Fig. 4 dargestellten Ausführung sind allerdings keine Eingänge für die Kontakte 51 und 53 vorgesehen, über die an die Kontakte 51, 53 eine externe Spannung angelegt wird. Dementsprechend ist der Wechselschalter 80 hier in die Schaltstellung gebracht, in der an dem elektrischen Kontakt 51 eine Spannung mit positiver Polarität und dem weiteren elektrischen Kontakt eine Spannung nahe dem Bezugspotential 19 anliegt, sodass das Schaltelement 59 durchschaltet und das weitere Schaltelement 61 blockiert, sofern an den elektrischen Kontakten 2, 3 sowie 45, 46 jeweils eine Spannung mit der richtigen Polarität anliegt.

### BEZUGSZEICHENLISTE

- 1: Prüfvorrichtung
- 2: elektrischer Kontakt
- 3: elektrischer Kontakt
- 4: Eingang
- 5: Eingang
- 6: Eingang
- 7: Eingang
- 8: Kombinationsschaltung
- 9: Pol
- 10: Pol
- 11: Pol
- 12: Pol
- 13: Gleichspannungsquelle
- 14: Gleichspannungsquelle
- 15: String
- 16: String
- 17: Zusammenführungsschaltung
- 18: Wechselrichter
- 19: Bezugspotential
- 20: Erde
- 21: Eingangswiderstand
- 22: Eingangswiderstand
- 23: Schaltelement
- 24: Schaltelement
- 25: Halbleiterschaltelement
- 26: Halbleiterschaltelement
- 27: Steuereingang
- 28: Steuereingang
- 29: Bezugseingang
- 30: Bezugseingang
- 31: Signalelement
- 32: Leuchtdiode/LED
- 33: Energiespeicher
- 34: Kondensator
- 35: spannungsbegrenzende Diode
- 36: Zener-Diode
- 37: Diode
- 38: Diode
- 39: Diode
- 40: Diode
- 41: Strombegrenzer
- 42: Transistor
- 43: Widerstand
- 44: Schalter
- 45: elektrischer Kontakt
- 46: elektrischer Kontakt
- 47: Eingangswiderstand
- 48: Eingangswiderstand
- 49: Schaltelement
- 50: Schaltelement
- 51: elektrischer Kontakt
- 52: elektrischer Kontakt
- 53: elektrischer Kontakt
- 54: elektrischer Kontakt
- 55: Eingangswiderstand
- 56: Eingangswiderstand
- 57: Eingangswiderstand
- 58: Eingangswiderstand
- 59: Schaltelement
- 60: Schaltelement
- 61: Schaltelement
- 62: Schaltelement
- 63: Ausgang
- 64: Signalelement
- 65: Widerstand
- 66: Widerstand
- 67: Widerstand
- 68: Widerstand
- 69: Widerstand
- 70: Widerstand
- 71: Widerstand
- 72: Widerstand
- 73: Signalelement
- 74: Signalelement
- 75: Signalelement
- 76: Signalelement
- 77: Wechselschalter
- 78: Wechselschalter
- 79: Wechselschalter
- 80: Wechselschalter
- 81: Zusammenführungsschalter
- 82: Zusammenführungsschalter
- 83: Sicherung
- 84: Sicherung
- 85: Sicherung
- 86: Sicherung
- 87: Schalter

## Patentansprüche

1. Prüfvorrichtung (1) zum Überprüfen von Polaritäten von einzeln an nicht miteinander verbundene Eingänge (4 bis 7) einer Kombinationsschaltung (8) angeschlossenen Polen (9 bis 12) von Gleichspannungsquellen (13, 14) gegenüber einem Bezugspotential (19) mit
- mindestens zwei jeweils einem der Eingänge (4 bis 7) zugeordneten und mit diesem verbindbaren elektrischen Kontakten (2, 3, 51, 52) und
- einem Signalelement (31),
wobei
- die mindestens zwei elektrischen Kontakte (2, 3, 51, 52) Eingängen (4, 5) zugeordnet sind, die jeweils für einen der Pole (9 bis 12) von einer von mindestens zwei der Gleichspannungsquellen (13, 14) vorgesehen sind, und
- jeder der mindestens zwei elektrischen Kontakte (2, 3, 51, 52) an jeweils ein Schaltelement (23, 24, 59, 60) angeschlossen ist, das abhängig von der Polarität einer Spannung, welche an dem elektrischen Kontakt (2, 3, 51, 52) anliegt, gegenüber dem Bezugspotential (19) ein elektrisches Signal zu dem Signalelement (31) blockiert,
**dadurch gekennzeichnet,**
- **dass** die Schaltelemente (23, 24, 59, 60) elektrisch in Reihe geschaltet sind und
- **dass** jedes der Schaltelemente (23, 24, 59, 60) dazu eingerichtet ist, bei fehlender Übereinstimmung der Polarität der Spannung, welche an dem elektrischen Kontakt (2, 3, 51, 52) anliegt, mit einer für den jeweiligen elektrischen Kontakt (2, 3, 51, 52) vorgegebenen Polarität gegenüber dem Bezugspotential (19) das elektrische Signal zu dem Signalelement (31) zu blockieren,
- so dass das Signalelement (31) nur bei Übereinstimmung aller Polaritäten der Spannungen, die über die zugeordneten Eingänge (4 bis 7) an den mindestens zwei elektrischen Kontakten (2, 3, 51, 52) anliegen, mit den jeweils vorgegebenen Polaritäten gegenüber dem Bezugspotential (19) mit dem elektrischen Signal zur Ausgabe eines Übereinstimmungssignals beaufschlagt ist.

2. Prüfvorrichtung (1) nach Anspruch 1, **dadurch gekennzeichnet, dass** die Prüfvorrichtung (1) weitere elektrische Kontakte (45, 46, 53, 54) aufweist, die anderen Eingängen (6, 7) zugeordnet und mit diesen verbindbar sind, wobei die anderen Eingänge (6, 7) jeweils für den anderen der Pole (9 bis 12) von einer der Gleichspannungsquellen (13, 14) vorgesehen sind.

3. Prüfvorrichtung (1) nach einem der vorhergehenden Ansprüche, **dadurch gekennzeichnet, dass** das Bezugspotential (19) vorgegeben ist durch:
- Erde (20) oder ein anderes von extern vorgegebenes absolutes elektrisches Potential;
- den Mittelwert von an allen elektrischen Kontakten (2, 3, 51, 52) anliegenden elektrischen Potentialen;
- den Mittelwert von an allen weiteren elektrischen Kontakten (45, 46, 53, 54) anliegenden elektrischen Potentialen;
- den Mittelwert von an allen elektrischen Kontakten (2, 3, 51, 52) und allen weiteren elektrischen Kontakten (45, 46, 53, 54) anliegenden elektrischen Potentialen mit negativer oder positiver Polarität oder
- das an allen elektrischen Kontakten (2, 3, 51, 52) und allen weiteren elektrischen Kontakten (45, 46, 53, 54) anliegende niedrigste oder höchste elektrische Potential.

4. Prüfvorrichtung (1) nach Anspruch 2 oder Anspruch 3 soweit rückbezogen auf Anspruch 2, **dadurch gekennzeichnet, dass** mindestens ein weiteres Signalelement (64) vorgesehen ist, das bei fehlender Übereinstimmung der Polarität der Spannung, welche über den zugeordneten Eingang (6, 7) an einem der weiteren elektrischen Kontakte (45, 46, 53, 54) anliegt, mit einer für den weiteren elektrischen Kontakt (45, 46, 53, 54) vorgegebenen Polarität gegenüber dem Bezugspotential (19) mit einem weiteren elektrischen Signal zur Ausgabe eines Fehlersignals beaufschlagt ist.

5. Prüfvorrichtung (1) nach Anspruch 4, **dadurch gekennzeichnet, dass** für jeden der weiteren elektrischen Kontakte (45, 46, 53, 54) jeweils ein weiteres Signalelement (73 bis 76) zur Ausgabe eines Fehlersignals vorgesehen ist.

6. Prüfvorrichtung (1) nach Anspruch 4 oder 5, **dadurch gekennzeichnet, dass** jeder weitere elektrische Kontakt (45, 46, 53, 54) an ein weiteres Schaltelement (49, 50, 61, 62) angeschlossen ist, wobei die weiteren Schaltelemente (49, 50, 61, 62) dazu eingerichtet sind, bei fehlender Übereinstimmung der Polarität der Spannung, welche an einem der weiteren elektrischen Kontakte (45, 46, 53, 54) anliegt, mit einer für den weiteren elektrischen Kontakt (45, 46, 53, 54) vorgegebenen Polarität gegenüber dem Bezugspotential (19) das weitere elektrische Signal zu dem zugehörigen weiteren Signalelement (64, 73 bis 76) durchzulassen.

7. Prüfvorrichtung (1) nach einem der vorhergehenden Ansprüche, **dadurch gekennzeichnet, dass** alle Schaltelemente (23, 24, 59, 60 und 49, 50, 61, 62) Halbleiterschaltelemente (25, 26) sind, wobei die Halbleiterschaltelemente (25, 26) optional selbstsperrende Halbleiterschaltelemente sind.

8. Prüfvorrichtung (1) nach Anspruch 7, **dadurch gekennzeichnet, dass** jedes Halbleiterschaltelement (25, 26) einen auf dem Bezugspotential (19) liegenden Bezugseingang (29, 30) und einen Steuereingang (27, 28) aufweist, an dem eine Spannung mit der gleichen Polarität wie die an dem zugehörigen elektrischen Kontakt (2, 3, 51, 52) und/oder der weiteren elektrischen Kontakt (45, 46, 53, 54) anliegende Spannung anliegt, wobei jedes Halbleiterschaltelement (25, 26) optional blockiert, wenn das Bezugspotential (19) auch an seinem Steuereingang (27, 28) anliegt.

9. Prüfvorrichtung (1) nach Anspruch 8, **dadurch gekennzeichnet, dass** jedem Halbleiterschaltelement (25, 26) zwei in gleicher Durchlassrichtung ausgerichtete Dioden (37 bis 40) zugeordnet sind, wobei die eine Diode (37, 39) elektrisch zwischen den Bezugseingang (29, 30) und den Steuereingang (27, 28) geschaltet ist und die andere Diode (38, 40) elektrisch zwischen den Steuereingang (27, 28) und einen gemeinsamen Ausgang der in Reihe geschalteten Halbleiterschaltelemente (25, 26) geschaltet ist.

10. Prüfvorrichtung (1) nach einem der vorhergehenden Ansprüche, **dadurch gekennzeichnet, dass** Schaltstellungen der Schaltelemente (23, 24, 59, 60) und/oder der weiteren Schaltelemente (49, 50, 61, 62), in denen sie das elektrische Signal blockieren oder durchlassen und die sie einnehmen, ohne dass an den ihnen zugeordneten elektrischen Kontakten (2, 3, 51, 52) und/oder der weiteren elektrischen Kontakten (45, 46, 53, 54) eine Spannung anliegt, einstellbar sind.

11. Prüfvorrichtung (1) nach einem der vorhergehenden Ansprüche, **dadurch gekennzeichnet, dass** an jedem der elektrischen Kontakte (2, 3, 51, 52) und/oder der weiteren elektrischen Kontakte (45, 46, 53, 54), an denen keine Spannung anliegt, weil an die zugehörigen Eingänge (4 bis 7) keine Spannungsquelle angeschlossen ist, eine Spannung anliegt, deren Polarität mit der jeweils vorgegebenen Polarität gegenüber dem Bezugspotential (19) übereinstimmt.

12. Prüfvorrichtung (1) nach einem der vorhergehenden Ansprüche, **dadurch gekennzeichnet, dass** an jedem der elektrischen Kontakte (2, 3, 51, 52) und/oder der weiteren elektrischen Kontakte (45, 46, 53, 54), an denen keine Spannung anliegt, obwohl an die zugehörigen Eingänge (4 bis7) eine Spannungsquelle angeschlossen sein sollte, eine Spannung anliegt, deren Polarität mit der jeweils vorgegebenen Polarität gegenüber dem Bezugspotential (19) nicht übereinstimmt.

13. Prüfvorrichtung (1) nach einem der vorhergehenden Ansprüche, **dadurch gekennzeichnet, dass** das Signalelement/die Signalelemente (31, 64, 73 bis 76) eine Leuchtdiode/Leuchtdioden (32) sind.

14. Prüfvorrichtung (1) nach einem der vorhergehenden Ansprüche, **dadurch gekennzeichnet, dass** ein Energiespeicher (33) vorgesehen ist, über den das Signalelement/die Signalelement (31, 64, 73 bis 76) bei Vorliegen des elektrischen Signals zur Ausgabe des Übereinstimmungssignals und/oder des weiteren elektrischen Signals zur Ausgabe des Fehlersignals mit elektrischer Energie versorgbar ist, wobei der Energiespeicher (33) optional ein mittels an den elektrischen Kontakten (2, 3, 51, 52) anliegenden Spannungen aufladbarer Kondensator (34) mit einer elektrisch parallel geschalteten spannungsbegrenzenden Diode (35) ist.

15. Prüfvorrichtung (1) nach einem der vorhergehenden Ansprüche, die als Handgerät mit einem Gehäuse und einer Anschlussleiste, über die die Eingänge (4 bis 7) der Kombinationsschaltung (8) in fester Zuordnung mit den elektrischen Kontakten (2, 3, 51, 52) und/oder den weiteren elektrischen Kontakten (45, 46, 53, 54) verbindbar sind, ausgebildet ist.

## Claims

1. Test device (1) for checking polarities of poles (9 to 12) of DC voltage sources (13, 14), which poles are individually connected to inputs (4 to 7) of a combination circuit (8), which inputs are not connected to one another, with respect to a reference-ground potential (19), the test device (1) comprising
- at least two electrical contacts (2, 3, 51, 52) respectively associated with one of the inputs (4 to 7) and connectable thereto and
- a signal element (31),
wherein
- the at least two electrical contacts (2, 3, 51, 52) are associated with inputs (4, 5), which are respectively provided for one of the poles (9 to 12) of one of at least two of the DC voltage sources (13, 14), and
- each of the at least two electrical contacts (2, 3, 51, 52) is connected to a respective switching element (23, 24, 59, 60), which blocks an electrical signal to the signal element (31) depending on the polarity of a voltage applied to the electrical contact (2, 3, 51, 52) with respect to the reference-ground potential (19),
**characterized in that**
- the switching elements (23, 24, 59, 60) are electrically connected in series and
- each of the switching elements (23, 24, 59, 60) is configured to block the electrical signal to the signal element (31) in the event that the polarity of the voltage applied to the electrical contact (2, 3, 51, 52) does not match a polarity prescribed for the respective electrical contact (2, 3, 51, 52) with respect to the reference-ground potential (19),
- such that the signal element (31) is supplied with the electrical signal for outputting a match signal only in the event that all of the polarities of the voltages applied to the at least two electrical contacts (2, 3, 51, 52) via the associated inputs (4 to 7) match the respectively prescribed polarities with respect to the reference-ground potential (19).

2. Test device (1) according to Claim 1, **characterized in that** the test device (1) comprises further electrical contacts (45, 46, 53, 54), which are associated with other inputs (6, 7) and connectable thereto, wherein the other inputs (6, 7) are respectively provided for the other of the poles (9 to 12) of one of the DC voltage sources (13, 14).

3. Test device (1) according to either of the preceding claims, **characterized in that** the reference-ground potential (19) is prescribed by:
- earth (20) or another externally prescribed absolute electrical potential;
- the mean value of electrical potentials applied to all of the electrical contacts (2, 3, 51, 52);
- the mean value of electrical potentials applied to all of the further electrical contacts (45, 46, 53, 54) ;
- the mean value of electrical potentials having a negative or positive polarity applied to all of the electrical contacts (2, 3, 51, 52) and all of the further electrical contacts (45, 46, 53, 54) or
- the lowest or highest electrical of the electrical potentials applied to all of the electrical contacts (2, 3, 51, 52) and all of the further electrical contacts (45, 46, 53, 54).

4. Test device (1) according to Claim 2 or Claim 3 insofar as referring back to Claim 2, **characterized in that** at least one further signal element (64) is provided, which is supplied with a further electrical signal for outputting a fault signal in the event that the polarity of the voltage applied to one of the further electrical contacts (45, 46, 53, 54) via the associated input (6, 7) does not match a polarity prescribed for the further electrical contact (45, 46, 53, 54) with respect to the reference-ground potential (19) .

5. Test device (1) according to Claim 4, **characterized in that** a respective further signal element (73 to 76) is provided for each of the further electrical contacts (45, 46, 53, 54) for outputting a fault signal.

6. Test device (1) according to Claim 4 or 5, **characterized in that** each further electrical contact (45, 46, 53, 54) is connected to a further switching element (49, 50, 61, 62), wherein the further switching elements (49, 50, 61, 62) are configured to allow the further electrical signal to pass to the associated further signal element (64, 73 to 76) in the event that the polarity of the voltage applied to one of the further electrical contacts (45, 46, 53, 54) does not match a polarity prescribed for the further electrical contact (46, 46, 53, 54) with respect to the reference-ground potential (19).

7. Test device (1) according to one of the preceding claims, **characterized in that** all of the switching elements (23, 24, 59, 60 and 49, 50, 61, 62) are semiconductor switching elements (25, 26), wherein the semiconductor switching elements (25, 26) are optionally normally off semiconductor switching elements.

8. Test device (1) according to Claim 7, **characterized in that** each semiconductor switching element (25, 26) comprises a reference-ground input (29, 30) at the reference potential (19) and a control input (27, 28) to which a voltage having the same polarity as the voltage applied to the associated electrical contact (2, 3, 51, 52) and/or the further electrical contact (45, 46, 53, 54) is applied, wherein each semiconductor switching element (25, 26) optionally blocks when the reference-ground potential (19) is also applied to the control input (27, 28) of said semiconductor switching element.

9. Test device (1) according to Claim 8, **characterized in that** two diodes (37 to 40) oriented in the same forward direction are associated with each semiconductor switching element (25, 26), wherein one diode (37, 39) is electrically connected between the reference-ground input (29, 30) and the control input (27, 28) and the other diode (38, 40) is electrically connected between the control input (27, 28) and a common output of the series-connected semiconductor switching elements (25, 26).

10. Test device (1) according to one of the preceding claims, **characterized in that** switching positions of the switching elements (23, 24, 59, 60) and/or the further switching elements (49, 50, 61, 62), in which they block the electrical signal or allow it pass and which they assume without a voltage being applied to the electrical contacts (2, 3, 51, 52) and/or the further electrical contacts (45, 46, 53, 54) associated therewith, can be set.

11. Test device (1) according to one of the preceding claims, **characterized in that** a voltage whose polarity matches the respective prescribed polarity with respect to the reference-ground potential (19) is applied to each of the electrical contacts (2, 3, 51, 52) and/or the further electrical contacts (45, 46, 53, 54) to which no voltage is applied because no voltage source is connected to the associated inputs (4 to 7).

12. Test device (1) according to one of the preceding claims, **characterized in that** a voltage whose polarity does not match the respective prescribed polarity with respect to the reference-ground potential (19) is applied to each of the electrical contacts (2, 3, 51, 52) and/or the further electrical contacts (45, 46, 53, 54) to which no voltage is applied even though a voltage source is supposed to be connected to the associated inputs (4 to 7).

13. Test device (1) according to one of the preceding claims, **characterized in that** the signal element/the signal elements (31, 64, 73 to 76) is/are a light-emitting diode/light-emitting diodes (32).

14. Test device (1) according to one of the preceding claims, **characterized in that** an energy store (33) is provided, by means of which the signal element/the signal elements (31, 64, 73 to 76) can be supplied with electrical energy in the presence of the electrical signal for outputting the match signal and/or the further electrical signal for outputting the fault signal, wherein the energy store (33) is optionally a capacitor (34) able to be charged by means of voltages applied to the electrical contacts (2, 3, 51, 52) and having a voltage-limiting diode (35) electrically connected in parallel.

15. Test device (1) according to one of the preceding claims, which is designed as a hand-held appliance comprising a housing and a connection strip by means of which the inputs (4 to 7) of the combination circuit (8) can be connected in fixed association with the electrical contacts (2, 3, 51, 52) and/or the further electrical contacts (45, 46, 53, 54).

## Revendications

1. Ensemble de vérification (1) servant à vérifier la polarité par rapport à un potentiel de référence (19) de pôles (9 à 12) de sources (13, 14) de tension continue, les pôles étant raccordés à des entrées (4 à 7), non reliées les unes aux autres, d'un circuit combiné (8), l'ensemble présentant :
- au moins deux contacts électriques (2, 3, 51, 52) associés à chacune des entrées (4 à 7) et aptes à être raccordés à ces dernières et
- un élément de signalisation (31),
- les deux ou plusieurs contacts électriques (2, 3, 51, 52) étant associés à des entrées (4, 5) prévues chacune pour l'un des pôles (9 à 12) de l'une parmi au moins deux sources (13, 14) de tension continue et
- chacun des deux ou plusieurs contacts électriques (2, 3, 51, 52) étant raccordé à un élément de commutation (23, 24, 59, 60) qui bloque le passage d'un signal électrique à l'élément de signalisation (31) en fonction de la polarité de la tension appliquée sur le contact électrique (2, 3, 51, 52) par rapport au potentiel de référence (19),
**caractérisé en ce que**
- les éléments de commutation (23, 24, 59, 60) sont raccordés électriquement en série et
- **en ce que** chacun des éléments de commutation (23, 24, 59, 60) est conçu pour bloquer le passage du signal électrique à l'élément de signalisation (31) en cas d'absence de correspondance entre la polarité de la tension appliquée sur le contact électrique (2, 3, 51, 52) concerné et une polarité prédéterminée du contact électrique (2, 3, 51, 52) concerné par rapport au potentiel de référence (19),
- de telle sorte que le signal électrique est appliqué sur l'élément de signalisation (31) pour délivrer un signal de correspondance uniquement en cas de correspondance entre toutes les polarités des tensions appliquées par l'intermédiaire des entrées (4 à 7) sur les deux ou plusieurs contacts électriques (2, 3, 51, 52) et chacune des polarités prédéterminées par rapport au potentiel de référence (19).

2. Ensemble de vérification (1) selon la revendication 1, **caractérisé en ce que** l'ensemble de vérification (1) présente d'autres contacts électriques (45, 46, 53, 54) associés à d'autres entrées (6, 7) et aptes à être raccordés à ces dernières, chacune des autres entrées (6, 7) étant prévue pour l'autre des pôles (9 à 12) de l'une des sources (13, 14) de tension continue.

3. Ensemble de vérification (1) selon l'une des revendications précédentes, **caractérisé en ce que** le potentiel de référence (19) est prédéterminé par :
- la terre (20) ou un autre potentiel électrique absolu prédéterminé par voie externe,
- la valeur moyenne des potentiels électriques appliqués sur tous les contacts électriques (2, 3, 51, 52),
- la valeur moyenne de tous les potentiels électriques appliqués sur les autres contacts électriques (45, 46, 53, 54),
- la valeur moyenne des potentiels électriques à polarité négative ou positive appliqués sur tous les contacts électriques (2, 3, 51, 52) et sur tous les autres contacts électriques (45, 46, 53, 54) ou
- le potentiel électrique le plus bas ou le plus haut appliqué sur tous les contacts électriques (2, 3, 51, 52) et sur tous les autres contacts électriques (45, 46, 53, 54).

4. Ensemble de vérification (1) selon la revendication 2 ou la revendication 3 dans la mesure où elle est subordonnée à la revendication 2, **caractérisé en ce qu'**il présente au moins un autre élément de signalisation (64) sur lequel est appliqué un autre signal électrique permettant d'émettre un signal d'erreur et qui, en cas d'absence de correspondance entre la polarité de la tension appliquée sur l'un des autres contacts électriques (45, 46, 53, 54) par l'intermédiaire de l'entrée (6, 7) associée et une polarité par rapport au potentiel de référence (19) prédéterminée pour l'autre contact électrique (45, 46, 53, 54) .

5. Ensemble de vérification (1) selon la revendication 4, **caractérisé en ce qu'**un autre élément de signalisation (73 à 76) est prévu pour chacun des autres contacts électriques (45, 46, 53, 54) en vue d'émettre un signal d'erreur.

6. Ensemble de vérification (1) selon la revendication 4 ou 5, **caractérisé en ce que** chacun des autres contacts électriques (45, 46, 53, 54) est raccordé à un autre élément de commutation (49, 50, 61, 62), les autres éléments de commutation (49, 50, 61, 62) étant conçus pour laisser passer l'autre signal électrique vers l'autre élément de signalisation (64, 73 à 76) associé en cas d'absence de correspondance entre les polarités de la tension appliquée sur l'un des autres contacts électriques (45, 46, 53, 54) et une polarité par rapport au potentiel de référence (19) prédéterminée pour l'autre contact électrique (45, 46, 53, 54) .

7. Ensemble de vérification (1) selon l'une des revendications précédentes, **caractérisé en ce que** tous les éléments de commutation (23, 24, 59, 60 et 49, 50, 61, 62) sont des éléments de commutation semi-conducteurs (25, 26), les éléments de commutation semi-conducteurs (25, 26) étant facultativement des éléments de commutation semi-conducteurs autobloquants.

8. Ensemble de vérification (1) selon la revendication 7, **caractérisé en ce que** chacun des éléments de commutation semi-conducteurs (25, 26) présente une entrée de référence (29, 30) placée au potentiel de référence (19) et une entrée de commande (27, 28) sur laquelle est appliquée une tension qui présente la même tension que la tension appliquée sur le contact électrique (2, 3, 51, 52) associé et/ou sur l'autre contact électrique (45, 46, 53, 54), chacun des éléments de commutation semi-conducteurs (25, 26) bloquant facultativement si le potentiel de référence (19) est également appliqué sur son entrée de commande (27, 28).

9. Ensemble de vérification (1) selon la revendication 8, **caractérisé en ce que** deux diodes (37 à 40) orientées dans la même direction de passage sont associées à chacun des éléments de commutation semi-conducteurs (25, 26), une diode (37, 39) étant raccordée électriquement entre l'entrée de référence (29, 30) et l'entrée de commande (27, 28) et l'autre diode (38, 40) étant raccordée électriquement entre l'entrée de commande (27, 28) et une sortie commune des éléments de commutation semi-conducteurs (25, 26) raccordés en série.

10. Ensemble de vérification (1) selon l'une des revendications précédentes, **caractérisé en ce que** les positions de commutation dans lesquelles les éléments de commutation (23, 24, 59, 60) et/ou les autres éléments de commutation (49, 50, 61, 62) bloquent le signal électrique ou le laissent passer et qu'ils prennent lorsqu'aucune tension n'est appliquée sur les contacts électriques (2, 3, 51, 52) et/ou sur les autres contacts électriques (45, 46, 53, 54) qui leur sont associés sont réglables.

11. Ensemble de vérification (1) selon l'une des revendications précédentes, **caractérisé en ce qu'**une tension dont la polarité correspond à la polarité prédéterminée par rapport au potentiel de référence (19) est appliquée sur chacun des contacts électriques (2, 3, 51, 52) et/ou des autres contacts électriques (45, 46, 53, 54) sur lesquels aucune tension n'est appliquée parce qu'aucune source de tension n'est raccordée aux entrées (4 à 7) associées.

12. Ensemble de vérification (1) selon l'une des revendications précédentes, **caractérisé en ce qu'**une tension dont la polarité ne correspond pas à la polarité prédéterminée par rapport au potentiel de référence (19) est appliquée sur chacun des contacts électriques (2, 3, 51, 52) et/ou des autres contacts électriques (45, 46, 53, 54) sur lesquels aucune tension n'est appliquée bien qu'une source de tension doive être raccordée aux entrées (4 à 7) associées.

13. Ensemble de vérification (1) selon l'une des revendications précédentes, **caractérisé en ce que** le ou les éléments de signalisation (31, 64, 73 à 76) sont des diodes luminescentes (32).

14. Ensemble de vérification (1) selon l'une des revendications précédentes, **caractérisé en ce qu'**il présente un accumulateur d'énergie (33) par lequel le ou les éléments de signalisation (31, 64, 73 à 76) peuvent être alimentés en énergie électrique lorsque le signal électrique qui délivre le signal de correspondance et/ou l'autre signal électrique qui délivre le signal d'erreur sont présents, l'accumulateur d'énergie (33) étant facultativement un condensateur (34) qui peut être chargé au moyen des tensions appliquées sur les contacts électriques (2, 3, 51, 52), et en parallèle duquel une diode (35) de limitation de tension est raccordée électriquement.

15. Ensemble de vérification (1) selon l'une des revendications précédentes, configuré comme appareil manuel présentant un boîtier et une barrette de raccordement par laquelle les entrées (4 à 7) du circuit combiné (8) peuvent être raccordées en association fixe aux contacts électriques (2, 3, 51, 52) et/ou aux autres contacts électriques (45, 46, 53, 54) .
